# EUROPEAN PATENT SPECIFICATION

(11) **EP 2 978 882 B1**
(45) Date of publication and mention of the grant of the patent: **24.06.2020**
(21) Application number: 13880194.9
(22) Date of filing: 27.03.2013
(51) Int. Cl.: H01L 21/322, H01L 21/324, C30B 33/02, C30B 29/40

(54) **CONTROLLABLE OXYGEN CONCENTRATION IN SEMICONDUCTOR SUBSTRATE**
STEUERBARE SAUERSTOFFKONZENTRATION IN HALBLEITERSUBSTRAT
CONCENTRATION RÉGULABLE EN OXYGÈNE DANS UN SUBSTRAT SEMI-CONDUCTEUR

(43) Date of publication of application: 03.02.2016
(73) Proprietor: Beijing Tongmei Xtal Technology Co., Ltd., Beijing 101113 (CN)
(72) Inventor: YOUNG, Morris, Fremont, California 94538 (US); ZHANG, Davis, Fremont, California 94538 (US); LIU, Vincent Wensen, Beijing 101113 (CN); WANG, Yuanli, Beijing 101113 (CN)
(74) Representative: Papula Oy
(86) International application number: PCT/CN2013/073260
(87) International publication number: WO 2014/153734

(56) References cited:
- WO-A1-2013/023194
- WO-A2-03/036697
- JP-A- H06 305 900
- JP-A- H08 255 790
- JP-A- H09 194 300
- JP-A- H11 116 373
- JP-A- 2002 013 966
- JP-A- 2007 106 669
- US-A1- 2015 279 678
- HULL B A ET AL: "Influence of oxygen on the activation of p-type GaN", APPLIED PHYSICS LETTERS, A I P PUBLISHING LLC, US, vol. 76, no. 16, 17 April 2000 (2000-04-17), pages 2271-2273, XP012025091, ISSN: 0003-6951, DOI: 10.1063/1.126318

## Description

### TECHNICAL FIELD

The example embodiments of the present invention generally relate to semiconductor fabrication, and more particularly to methods of controlling oxygen concentration in IIIA-VA compound semiconductor substrate.

### BACKGROUND

Group IIIA-VA semiconductor compounds, such as gallium arsenide (GaAs), indium phosphide (InP) and gallium phosphide (GaP), are widely used in the manufacture of devices, such as microwave frequency integrated circuits, infrared light-emitting diodes, laser diodes, solar cells, high-power and high-frequency electronics, and optical systems. The device yield and performance characteristics of many products are dependent on the presence of trace impurities in the semiconductor process gases used in their manufacture. As a result, impurities may be doped in single crystal substrates. Through applied effort, ingenuity, and innovation, solutions to improve such systems and methods have been realized and are described in connection with embodiments of the present invention.

### SUMMARY

According to the present invention, a method of controlling oxygen concentration in III-V compound semiconductor substrate is defined according to claim 1. It comprises providing a plurality of III-V crystal substrates in a sealable container, and providing a predetermined amount of material in the container. Atoms of predetermined amount of material have high chemical reactivity with oxygen atoms in the container, the material comprising at least one of carbon, aluminum, titanium, and boron. The method further comprises maintaining a predetermined pressure within the sealed container and annealing the plurality of III-V crystal substrates to yield an oxygen concentration in the crystal substrates. The oxygen concentration is associated with the predetermined amount of material having high oxygen reactivity with oxygen atoms. The annealing further comprises heating the container to a platform temperature between 1000°C and 1100°C at a predetermined heating rate of less than 100°C/hour.

US 2015/279678 discloses a process of annealing of GaAs at high temperature, preferably 1 000- 1 200 °C, in order to control the amount of Oxygen in the crystal, wherein the annealing tube contains Arsenic. Hull et al, in "Influence of oxygen on the activation of p-type GaN", Applied Physics Letters, vol. 76, n° 16 (April 2000), pages 2271-2273 discloses the use of a Titanium to getter Oxygen during annealing of GaN at 600-900 °C.

### BRIEF DESCRIPTION OF THE DRAWINGS

Having thus described the example embodiments of the present invention in general terms, reference will now be made to the accompanying drawings, which are not necessarily drawn to scale, and wherein:
FIG. 1 illustrates a method for controlling oxygen concentration in semiconductor substrates in accordance with some example embodiments;
FIG. 2 illustrates a sealed container with a plurality of crystal substrates and a predetermined amount of material having high chemical reactivity to oxygen atoms in accordance with some example embodiments;
FIG. 3 shows a table illustrating an example relationship between oxygen and carbon by weight;
FIG. 4 illustrates a graph showing an example relationship between oxygen and carbon weight in accordance with some example embodiments; and
FIG. 5 illustrates a schematic block diagram of circuitry that may be configured to control systems in accordance with some embodiments.

### DETAILED DESCRIPTION

The present disclosure now will be described more fully with reference to the accompanying drawings, in which some, but not all embodiments of the disclosure are shown. This disclosure may be embodied in many different forms and should not be construed as limited to the embodiments set forth; rather, these example embodiments are provided so that this disclosure will be thorough and complete, and will fully convey the scope of the disclosure to those skilled in the art. Like numbers refer to like elements throughout.

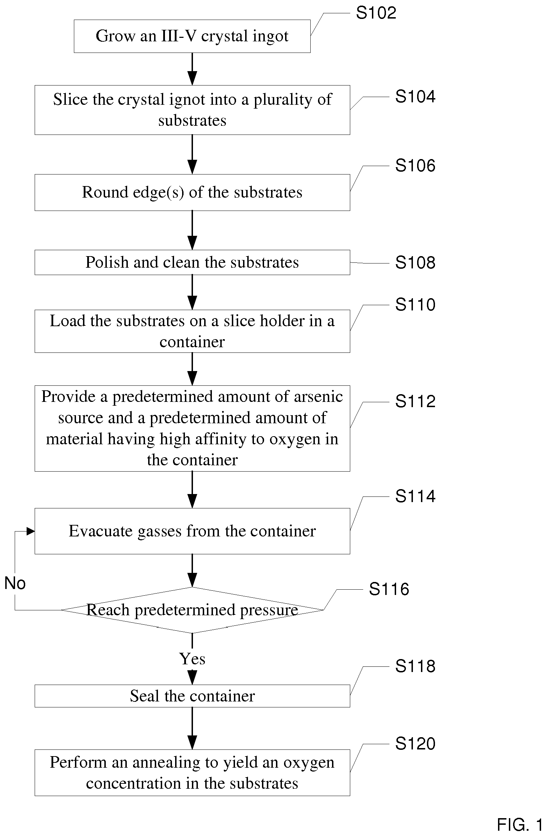

FIG. 1 illustrates an exemplary method for controlling oxygen concentration in III-V compound semiconductor substrates ("example," "exemplary" and like terms as used herein refer to "serving as an example, instance or illustration"). To facilitate explanation of the invention, the description will be focused on the particular III-V compound semiconductor material Gallium Arsenide("GaAs"),but the method may be easily applied to or adapted for other chemicals, such as, e.g., Indium phosphide(InP), Gallium phosphide (GaP)and/or other materials used in manufacturing semi-conductor substrates and/or for any other purpose. For example, some embodiments may include both a GaAs crystal growth process (an example which is described below in more detail) and an annealing process (described in more detail below) to achieve the ability to control the oxygen concentration in a GaAs substrate being manufactured.

Referring to FIG. 1 at step S102, a crystal growth furnace may be used in accordance with some embodiments to grow one or more semi-insulating GaAs single crystal ingots using any suitable crystal-growth procedure, such as Vertical Gradient Freeze process, Vertical Bridgman process, Liquid Encapsulated Czochralski process, any other suitable crystal growth process, or a combination of crystal-growth processes. A grinding device may perform a grinding process to make each grown GaAs single crystal ingot into a cylindrical shape and/or any other form. For example, a crystal ingot grown at S102 may be formed into a cylindrical having a 150mm (six-inch) diameter and any suitable length. As such, at least one crystal growth furnace may be configured to perform at least some of the functions associated with S102 using any suitable approach to result in, for example, a III-V single crystal that may be sliced and/or otherwise modified to have a desired thickness, taper, bow, etc.

At S104, a slicing machine, such as an inner diameter saw slicing machine, may be used to slice each GaAs single crystal ingot into a plurality of substrates using various cutting techniques in accordance with some embodiments. The cutting techniques may include, for example, wire saw technology (e.g., slurry wire slicing and diamond wire slicing), abrasive fluid cutting techniques, inner diameter saw slicing, and/or any other suitable cutting techniques.

At S106, the edge(s) of the substrate(s) may be beveled and/or otherwise rounded using an edge grinder and/or other suitable machine. Edges without grinding or rounding typically exhibit a surface pattern formed during the slicing process of S104. Surface valleys may trap particles and impurities. These particles may be propagated to the substrate surface and increase the risk of substrate chipping. As such, an edge grinder and/or other suitable machine may be used to round the edges thereby minimizing the surface irregularities to prevent the edge(s) of the substrates from chipping, fragmenting and/or otherwise being damaged in the subsequent process.

At S108, polishing machine(s) may be configured to perform a polishing process to polish one or more surfaces of each substrate. The polishing process may include performing a rough polishing process to remove surface damage on the substrates and a final polishing process (e.g., a chemical mechanical polish) to flatten the surface of each substrate. The polishing process may further comprise using cleaning equipment that is configured to perform a clean process to clean at least some of the remaining particles and residues from the substrate surface(s). For example, the cleaning equipment may be configured to perform a cleaning process, such as a dry chemical cleaning process, a wet chemical cleaning process, and/or any other type of cleaning process. When wet chemical cleaning process is performed during the manufacturing of GaAs substrates, chemical solutions may be used. For example, the GaAs substrates may be immersed into a cleaning solution(such as, e.g., NH₄OH:H₂O₂:H₂O mixture in a ratio 1:2:9) and removed therefrom one or more times. The GaAs substrates may then be rinsed in a rinse system using, for example, de-ionized water.

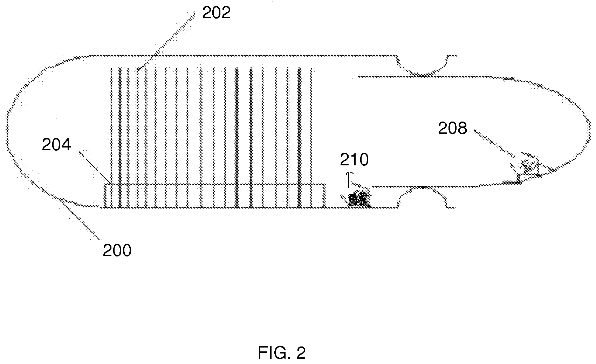

At S110, loading equipment, such as machines having tweezers-like components and/or other tools are used to load the sliced substrates on a substrate holder and then in a container. FIG. 2, for example, shows sliced substrates 202, substrate holder 204 and container 206. In some embodiments, substrate holder 204 may comprise a quartz boat. Container 206 may be a quartz tube, an ampoule or any other suitable containers.

At S112, to yield different levels of oxygen concentration in the GaAs and/or other type of substrate (s), a predetermined amount of material having high chemical reactivity with oxygen atoms, shown in FIG. 2 as material 210,may be provided into the container 206The predetermined amount of material may have a large negative enthalpy of reaction with oxygen atoms, for example, -98.4 KJ/mol. The material 210 may comprise at least one of carbon with an enthalpy of reaction of-98.4 KJ/mol, aluminum with an enthalpy of reaction of -273.4 KJ/mol, titanium with an enthalpy of reaction of -228.2 KJ/mol, boron with an enthalpy of reaction of -210.6KJ/mol,and/or any other material(s) having a large negative enthalpy of reaction with oxygen atoms. In an instance in which the substrate is GaAs, a predetermined amount of solid arsenic, shown in FIG. 2 as source 208, may be provided in the container, shown as the container 206. For example, source 208 may comprise 35 grams of solid arsenic source 208 and be placed in container 206 at S112. Material 210 may also or instead be provided at S112 in a predetermined amount, which may include a range of amounts. For example, the predetermined amount of material 210 may be any amount between zero and about 160grams. The amount of material 210 introduced at S112 may aid in achieving a specific predetermined range of oxygen concentration during the annealing step(s).

At S114, air and other gasses in container 206may be evacuated to a predetermined level of pressure by an evacuation system. The evacuation system may be a vacuum system, a pump, and/or any other devices that may evacuate gasses from container 206 until a predetermined pressure is reached. When the predetermined pressure (under approximately 10torr) is reached at S116, container 206may be sealed to maintain the predetermined pressure at S118.

At S120, container 206 and its contents, including sliced GaAs substrates 202, solid arsenic source 208 and material 210maythen be placed into an annealing furnace for annealing. The annealing furnace may be a horizontal-type annealing furnace, a vertical-type annealing furnace and/or any other types of annealing machines.

The annealing process may be optimized for heating rate, platform temperature, and/or cooling rate, among other things, to achieve controllable oxygen concentration. The container is heated at a heating rate of less than 100°C/hour. When a temperature of 1000 °C to 1100 °C is reached, the platform temperature may be held constant for 10-20 hours in accordance with some embodiments. Subsequently, the temperature may be decreased and the container may be allowed to cool to room temperature (and/or any other suitable temperature) at a cooling rate of, for example, less than 100°C/hour. In some embodiments, heating and cooling may be conducted slowly to avoid warping/cracking that may otherwise result from thermal gradients and/or thermo-elastic stresses within the crystal substrates. The heating and cooling process may also prevent or otherwise aid in reducing defects due to frictions of crystal structures at the interface between the crystal and the container, and/or on surfaces of the substrates.

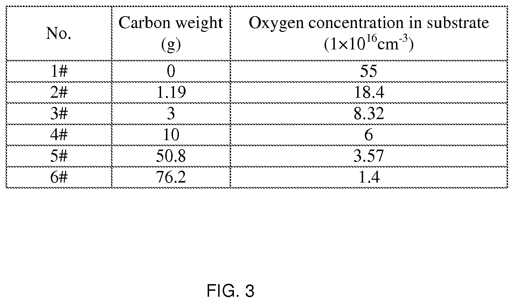

Once the substrates are annealed, a desired level of oxygen concentration is achieved. The oxygen concentration in each substrate may vary with the amount of oxygen affinity material 210 introduced at S112. For example, Table 1 of FIG. 3 showsan example where carbon is provided as the oxygen affinity material 210, and different levels of oxygen concentration is achieved in the substrates by providing differing amounts of carbon. As shown in Table 1, when no carbon is provided, the oxygen concentration in the substrates has been found to be approximately 55×10¹⁶ atoms/cm⁻³. With an increase (by weight) of the carbon added at S112 as the material 210, the oxygen concentration generated by the method of FIG. 1 in the system of FIG. 2 may decrease. As another example, when about 76.2 grams of carbon is provided as the oxygen affinity material, the oxygen concentration in the substrate is approximately 1.4×10¹⁶ atoms/cm⁻³.

As a result of the annealing process, the substrate has light point defect density as low as less than 0.25/cm². Compared to the crystal ingot prior to the annealing process, the light point defect density is largely decreased. The light point defects of the ultra-clean substrates may be detected, for example, by KLA-Tencor 6220.

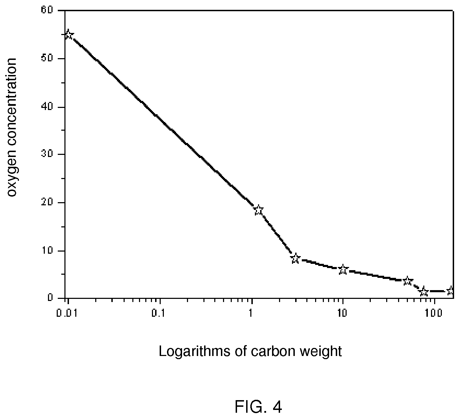

FIG. 4 illustrates a graph showing the relationship between oxygen concentration and logarithms of carbon weight based on table 1 of FIG. 3. As illustrated in FIG. 4, the oxygen concentration may change along with the carbon weight when used as the material 210. For example, by providing different amounts of carbon as the material 210, different levels of oxygen concentration are achieved in the substrates. Table 1 of FIG. 3, like the other drawings discussed herein, is in accordance with exemplary embodiments. Although carbon is used as the oxygen affinity material in these example embodiments, the oxygen affinity material is not limited to carbon and other oxygen affinity materials as defined in claim 1 may be used as the material 210. Additionally, carbon weight of the material 210 may change within the range which may result in different levels of oxygen concentration.

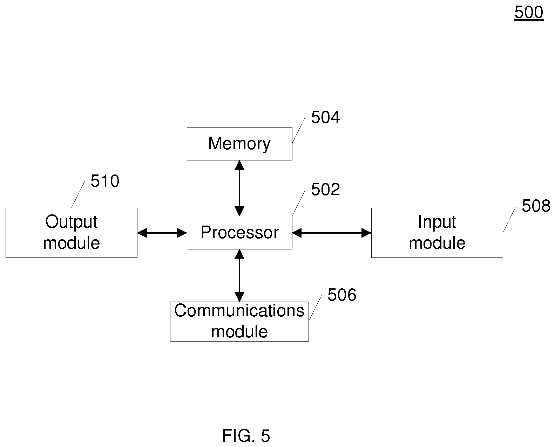

FIG. 5 shows a schematic block diagram of circuitry500, some or all of which may be included in, for example, the crystal growth furnace, the slicing machine, the grinding device, the polishing machine, the loading station, the evacuation system and/or the annealing furnace. As illustrated in FIG. 5, in accordance with some example embodiments, the circuitry 500 may include various means, such as one or more processors 502, memories 504, communications modules 506, inputmodules508and/or output modules 510.

## Claims

1. A method of controlling oxygen concentration in III-V compound semiconductor substrate, comprising:
providing a plurality of III-V crystal substrates in a sealable container;
providing a predetermined amount of material having high oxygen reactivity with oxygen atoms in the container, the material comprising at least one of carbon, aluminum, titanium, and boron;
maintaining a predetermined pressure within the sealed container; and annealing the plurality of III-V crystal substrates to yield an oxygen concentration in the crystal substrates, wherein the oxygen concentration is associated with the predetermined amount of material having high oxygen reactivity with oxygen atoms, wherein the annealing further comprises heating the container to a platform temperature between 1000°C and 1100°C at a predetermined heating rate of less than 100°C/hour.

2. The method of claim 1, wherein the annealing further comprises maintaining the platform temperature for 10-20 hours.

3. The method of claim 1, wherein the annealing further comprises cooling the container at a predetermined cooling rate of less than 100°C/hour.

4. The method of claim 1, further comprising providing a predetermined amount of source material in the container

5. The method of claim 1, further comprising providing a predetermined amount of solid arsenic source in the container.

6. The method of claim 1, further comprising performing vertical gradient freeze process to grow an III-V crystal ingot.

7. The method of claim 1, further comprising rounding an edge of the III-V crystal substrates.

8. The method of claim 1, wherein providing the plurality of III-V crystal substrates in the container further comprises loading the plurality of III-V crystal substrates on a substrate holder and loading the substrate holder in the container.

9. The method of claim 1, wherein maintaining the container at the predetermined pressure further comprises evacuating the container and sealing the container to maintain the container at a pressure under approximately 10torr.

10. The method of claim 1 further comprising slicing an III-V crystal ingot into the plurality of substrates.

11. The method of claim 1 further comprising cleaning the III-V crystal substrates by cleaning equipment.

## Patentansprüche

1. Verfahren zum Steuern der Sauerstoffkonzentration in einem III-V-Verbindungshalbleitersubstrat, umfassend:
Bereitstellen einer Vielzahl an III-V-Kristallsubstraten in einem verschließbaren Behälter;
Bereitstellen einer vorbestimmten Menge an Material aufweisend eine hohe Sauerstoffreaktivität mit Sauerstoffatomen in dem Behälter, das Material umfassend zumindest eins von Kohlenstoff, Aluminium, Titan und Bor;
Aufrechterhalten eines vorbestimmten Drucks innerhalb des verschlossenen Behälters; und
Tempern der Vielzahl an III-V-Kristallsubstraten, um eine Sauerstoffkonzentration in den Kristallsubstraten zu ergeben, wobei die Sauerstoffkonzentration mit der vorbestimmten Menge an Material aufweisend eine hohe Sauerstoffreaktivität mit Sauerstoffatomen verbunden ist, wobei das Tempern ferner Heizen des Behälters auf eine Plattformtemperatur zwischen 1000°C und 1100°C bei einer vorbestimmen Heizrate von weniger als 100°C/Stunde umfasst.

2. Verfahren von Anspruch 1, wobei das Tempern ferner Aufrechterhalten der Plattformtemperatur für 10-20 Stunden umfasst.

3. Verfahren von Anspruch 1, wobei das Tempern ferner Kühlen des Behälters bei einer vorbestimmen Kühlrate von weniger als 100°C/Stunde umfasst.

4. Verfahren von Anspruch 1, ferner umfassend Bereitstellen einer vorbestimmten Menge an Ausgangsmaterial in dem Behälter.

5. Verfahren von Anspruch 1, ferner umfassend Bereitstellen einer vorbestimmten Menge an fester Arsenquelle in dem Behälter.

6. Verfahren von Anspruch 1, ferner umfassend Durchführen eines Vertikalgradienten-Gefrierprozesses zum Züchten eines III-V-Kristallingots.

7. Verfahren von Anspruch 1, ferner umfassend Runden einer Kante der III-V- Kristallsubstrate.

8. Verfahren von Anspruch 1, wobei Bereitstellen der Vielzahl an III-V-Kristallsubstraten in dem Behälter ferner Laden der Vielzahl an III-V-Kristallsubstraten auf einen Substrathalter und Laden des Substrathalters in den Behälter umfasst.

9. Verfahren von Anspruch 1, wobei Aufrechterhalten des Behälters bei dem vorbestimmten Druck ferner Evakuieren des Behälters und Verschließen des Behälters umfasst, um den Behälter bei einem Druck unter circa 10 Torr aufrechtzuerhalten.

10. Verfahren von Anspruch 1, ferner umfassend Schneiden eines III-V-Kristallingots in die Vielzahl an Substraten.

11. Verfahren von Anspruch 1, ferner umfassend Reinigen der III-V-Kristallsubstrate durch Reinigungsausrüstung.

## Revendications

1. Procédé pour réguler la concentration d'oxygène dans un substrat semi-conducteur de composé III-V, comprenant :
la disposition d'une pluralité de substrats cristallins III-V dans un récipient hermétique ;
la disposition d'une quantité prédéterminée de matériau ayant une réactivité élevée vis-à-vis de l'oxygène avec des atomes d'oxygène dans le récipient, le matériau comprenant au moins l'un parmi le carbone, l'aluminium, le titane, et le bore ;
le maintien d'une pression prédéterminée dans le récipient hermétiquement fermé ; et
le recuit de la pluralité de substrats cristallins III-V pour engendrer une concentration d'oxygène dans les substrats cristallins, laquelle concentration d'oxygène est associée à la quantité prédéterminée de matériau ayant une réactivité élevée vis-à-vis des atomes d'oxygène, lequel recuit comprend en outre le chauffage du récipient à une température de plateforme comprise entre 1000°C et 1100°C à une vitesse de montée en température prédéterminée inférieure à 100°C/heure.

2. Procédé selon la revendication 1, dans lequel le recuit comprend en outre le maintien de la température de plateforme pendant 10-20 heures.

3. Procédé selon la revendication 1, dans lequel le recuit comprend en outre le refroidissement du récipient à une vitesse de refroidissement prédéterminée inférieure à 100°C/heure.

4. Procédé selon la revendication 1, comprenant en outre la disposition d'une quantité prédéterminée de matériau source dans le récipient.

5. Procédé selon la revendication 1, comprenant en outre la disposition d'une quantité prédéterminée d'une source d'arsenic solide dans le récipient.

6. Procédé selon la revendication 1, comprenant en outre la réalisation d'un traitement de congélation à gradient vertical pour la croissance d'un lingot de cristal III-V.

7. Procédé selon la revendication 1, comprenant en outre l'arrondissement d'un bord des substrats cristallins III-V.

8. Procédé selon la revendication 1, dans lequel la disposition de la pluralité de substrats cristallins III-V dans le récipient comprend en outre le chargement de la pluralité de substrats cristallins III-V sur un support de substrat et le chargement du support de substrat dans le récipient.

9. Procédé selon la revendication 1, dans lequel le maintien du récipient sous la pression prédéterminée comprend en outre l'évacuation du récipient et la fermeture hermétique du récipient pour que le récipient soit maintenu sous une pression inférieure à environ 10 torr.

10. Procédé selon la revendication 1, comprenant en outre la découpe d'un lingot en cristal III-V en la pluralité de substrats.

11. Procédé selon la revendication 1, comprenant en outre le nettoyage des substrats cristallins III-V par un équipement de nettoyage.
